# EUROPEAN PATENT SPECIFICATION

(11) **EP 4 481 982 B1**
(45) Date of publication and mention of the grant of the patent: **23.09.2026**
(21) Application number: 23897953.8
(22) Date of filing: 19.06.2023
(51) Int. Cl.: H02J 7/00, G01R 31/3835, G01R 31/367, H02J 7/52, H02J 7/54, H02J 7/80, H02J 7/82, H01M 10/44, H01M 10/42

(54) **BATTERY SYSTEM AND BATTERY BALANCING METHOD THEREOF**
BATTERIESYSTEM UND BATTERIEAUSGLEICHSVERFAHREN DAFÜR
SYSTÈME DE BATTERIE ET SON PROCÉDÉ D'ÉQUILIBRAGE DE BATTERIE

(30) Priority: 30.11.2022 KR 20220164439
(43) Date of publication of application: 25.12.2024
(73) Proprietor: LG Energy Solution, Ltd., Seoul 07335 (KR)
(72) Inventor: LEE, Hyunchul, Daejeon 34122 (KR); KWON, Dong Keun, Daejeon 34122 (KR); KIM, Seunghyun, Daejeon 34122 (KR)
(74) Representative: BCKIP Part mbB
(86) International application number: PCT/KR2023/008432
(87) International publication number: WO 2024/117413

(56) References cited:
- CN-B- 105 871 021
- KR-A- 20160 043 838
- KR-A- 20180 116 988
- KR-A- 20210 051 461
- KR-A- 20210 053 785
- KR-A- 20220 117 040
- US-A1- 2014 266 072
- US-A1- 2014 320 088
- US-B2- 10 003 106

## Description

### [Technical Field]

This application claims priority to and the benefit of Korean Patent Application No.10-2022-0164439 filed in the Korean Intellectual Property Office on November 30, 2022.

The present invention relates to a battery system and a battery balancing method thereof, and more particularly, to a battery system and a battery balancing method thereof, for balancing a battery having a voltage plateau in a charging characteristic curve.

### [Background Art]

A secondary battery is a battery that can be recharged and reused even after being discharged. The secondary battery can be used as an energy source for small devices such as mobile phones, tablet PCs and vacuum cleaners, and also used as an energy source for medium and large devices such as ESS (Energy Storage System) for automobiles and smart grids.

The secondary battery is applied to a system in a form of an assembly such as a battery module in which a plurality of battery cells are connected in series and parallel or a battery pack in which battery modules are connected in series and parallel according to system requirements. In a case of medium or large-sized devices such as electric vehicles, a high-capacity battery system in which a plurality of battery packs are connected in parallel may be applied in order to satisfy a required capacity of the device.

Carbon materials are mainly used as an anode active material of lithium secondary batteries, and lithium-containing cobalt oxide (LiCoO₂) is mainly used as a cathode active material. In addition, lithium-containing manganese oxides (LiMnO₂, LiMn2O₄, etc.) and lithium-containing nickel oxide (LiNiO₂) are also being considered.

Recently, a lithium iron phosphate (LiFePO4)-based compound has been used as a cathode active material for a lithium secondary battery. A lithium iron phosphate (LFP) battery using lithium iron phosphate as a cathode active material is superior in terms of thermal stability and cost efficiency compared to other types of batteries. However, the LFP battery shows a flat characteristic with a voltage plateau in a charging characteristic curve (a relationship curve between open circuit voltage and SOC), and a problem arises due to this that SOC (State Of Charge) cannot be accurately estimated in the plateau section.

In order to resolve imbalances between battery cells during operation of a battery system, cell balancing control based on an estimated SOC is value essential. However, in the case of the LFP battery, it is difficult to accurately estimate SOC in the plateau section, and thus, cell balancing control is performed only in non-flat sections (e.g., a section where the SOC is 90% or more, or a section where the SOC is 10% or less).

Accordingly, an appropriate control technique for balancing a battery having a voltage plateau in a charging characteristic curve, such as the LFP battery, is needed. The document US2014/266072 A1 discloses a battery management apparatus according to the state of the art.

### [Detailed Description of the Invention]

### [Technical Problem]

To obviate one or more problems of the related art, embodiments of the present disclosure provide a battery management apparatus for balancing a battery having a voltage plateau in a charging characteristic curve.

To obviate one or more problems of the related art, embodiments of the present disclosure also provide a battery balancing method by the battery management apparatus.

To obviate one or more problems of the related art, embodiments of the present disclosure also provide a battery management system comprising the battery management apparatus.

### [Technical Solution]

In order to achieve the objective of the present disclosure, a battery system includes: a battery assembly including a plurality of battery cells; and a battery management apparatus for collecting state information on the battery assembly and for managing and controlling the battery assembly based on the collected state information.

Here, the battery management apparatus may be configured to, in a charging mode of the battery assembly, check a charge rate of the battery assembly, and determine whether to initiate a balancing mode for balancing the plurality of battery cells based on the checked charge rate.

The battery management apparatus may be configured to, upon being switched to the charging mode of the battery assembly, check a constant power-rate (CP-rate) or a current-rate (C-rate) for charging the battery assembly.

The battery management apparatus may be configured to determine whether to initiate a balancing mode based on whether a pre-stored threshold voltage value or threshold SOC corresponding to the checked charge rate is reached.

The battery management apparatus may be configured to, in a process of charging the battery assembly, check a voltage value of the battery assembly at every predetermined time and initiate a balancing mode in the instance that the voltage value reaches the threshold voltage value.

The battery management apparatus may be configured to, in a process of charging the battery assembly, check a voltage value of the battery assembly at every predetermined time and initiate a balancing mode in the instance that a state of charge (SOC) which is calculated based on the voltage value reaches the threshold SOC.

A lower value for the threshold SOC may be defined as the charge rate of the battery assembly increases.

The threshold voltage value or the threshold SOC may be predefined based on a voltage-SOC correspondence curve or a voltage-SOC correspondence table derived in a pre-charging process according to the charge rate of the battery assembly.

The threshold voltage value may be defined as a voltage value at a point where a change amount in voltage value versus a unit change amount in SOC becomes greater than or equal to a preset reference value.

The threshold SOC may be defined as a SOC at a point where a change amount in voltage value versus a unit change amount in SOC becomes greater than or equal to a preset reference value.

The battery management apparatus may be configured to, upon the balancing mode being initiated, determine whether balancing is necessary based on the state information on the plurality of battery cells and perform at least one predefined control operation for balancing the plurality of battery cells when it is determined that balancing is necessary.

According to another embodiment of the present disclosure, a battery balancing method, to be performed by a battery management apparatus connected with a battery assembly including a plurality of battery cells, may include: checking a charge rate of the battery assembly in a charging mode of the battery assembly; and determining whether to initiate a balancing mode for balancing the plurality of battery cells based on the checked charge rate.

The checking a charge rate of the battery assembly may include, upon being switched to the charging mode of the battery assembly, checking a constant power-rate (CP-rate) or a current-rate (C-rate) for charging the battery assembly.

The determining whether to initiate a balancing mode may include determining whether to initiate a balancing mode based on whether a pre-stored threshold voltage value or threshold SOC corresponding to the checked charge rate is reached.

The determining whether to initiate a balancing mode may include: in a process of charging the battery assembly, checking a voltage value of the battery assembly at every predetermined time; and initiating a balancing mode in the instance that the voltage value reaches the threshold voltage value.

The determining whether to initiate a balancing mode may include: in a process of charging the battery assembly, checking a voltage value of the battery assembly at every predetermined time; and initiating a balancing mode in the instance that a state of charge (SOC) which is calculated based on the voltage value reaches the threshold SOC.

A lower value for the threshold SOC may be defined as the charge rate of the battery assembly increases.

The threshold voltage value or the threshold SOC may be predefined based on a voltage-SOC correspondence curve or a voltage-SOC correspondence table derived in a pre-charging process according to the charge rate of the battery assembly.

The threshold voltage value may be defined as a voltage value at a point where a change amount in voltage value versus a unit change amount in SOC becomes greater than or equal to a preset reference value.

The threshold SOC may be defined as a SOC at a point where a change amount in voltage value versus a unit change amount in SOC becomes greater than or equal to a preset reference value.

The method may further include: upon the balancing mode being initiated, determining whether balancing is necessary based on the state information on the plurality of battery cells; and performing at least one predefined control operation for balancing the plurality of battery cells when it is determined that balancing is necessary.

According to another embodiment of the present disclosure, a battery management apparatus, connected with a battery assembly including a plurality of battery cells, may include: at least one processor; and a memory configured to store at least one instruction executed by the at least one processor.

Here, the at least one instruction may include: an instruction to check a charge rate of the battery assembly in a charging mode of the battery assembly; and an instruction to determine whether to initiate a balancing mode for balancing the plurality of battery cells based on the checked charge rate.

The instruction to check a charge rate of the battery assembly may include an instruction to, upon being switched to the charging mode of the battery assembly, check a constant power-rate (CP-rate) or a current-rate (C-rate) for charging the battery assembly.

The instruction to determine whether to initiate a balancing mode may include an instruction to determine whether to initiate a balancing mode based on whether a pre-stored threshold voltage value or threshold SOC corresponding to the checked charge rate is reached.

The instruction to determine whether to initiate a balancing mode may include: an instruction to, in a process of charging the battery assembly, check a voltage value of the battery assembly at every predetermined time; and an instruction to initiate a balancing mode in the instance that the voltage value reaches the threshold voltage value.

The instruction to determine whether to initiate a balancing mode may include: an instruction to, in a process of charging the battery assembly, check a voltage value of the battery assembly at every predetermined time; and an instruction to initiate a balancing mode in the instance that a state of charge (SOC) which is calculated based on the voltage value reaches the threshold SOC.

The at least one instruction may further include: upon the balancing mode being initiated, an instruction to determine whether balancing is necessary based on the state information on the plurality of battery cells; and an instruction to perform at least one predefined control operation for balancing the plurality of battery cells when it is determined that balancing is necessary.

### [Advantageous Effects]

According to embodiments of the present disclosure, balancing control, in performing balancing of a battery having a plateau characteristic, is possible in a wider SOC range compared to the prior art.

In addition, according to the embodiment of the present invention as described above, in performing cell balancing for a battery having a plateau characteristic, unlike the prior art in which balancing can be performed by entering a balancing mode only in an idle state, balancing control can be performed by entering a balancing mode even in a charging state.

### [Brief Description of the Drawings]

FIG. 1 shows a charging characteristic curve of an LFP battery.
FIG. 2 is a block diagram illustrating a battery system according to the present invention.
FIG. 3 is an operation flowchart of a battery balancing method according to embodiments of the present invention.
FIG. 4 is a reference diagram for explaining a battery balancing method according to embodiments of the present invention.
FIG. 5 is a reference table for explaining a battery balancing method according to embodiments of the present invention.
FIG. 6 is an operation flowchart of a battery balancing method based on a threshold voltage value according to an embodiment of the present invention.
FIG. 7 is an operation flowchart of a battery balancing method based on a threshold SOC according to another embodiment of the present invention.
FIG. 8 is a block diagram of a battery management apparatus according to embodiments of the present invention.
10: battery cell
100: battery assembly
200, 800: battery management apparatus

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

A battery cell is a minimum unit that serves to store power and a battery module refers to an assembly in which a plurality of battery cells are electrically connected.

A battery pack or battery rack refers to a system of a minimum single structure which is assembled by electrically connecting module units, set by a battery manufacturer, and can be monitored and controlled by a battery management apparatus/system (BMS). A battery pack or battery rack may include several battery modules and a battery protection unit or any other protection device.

A battery bank refers to a group of large-scale battery rack systems configured by connecting several racks in parallel. A bank BMS for a battery bank may monitor and control several rack BMSs, each of which manages a battery rack.

A battery assembly may include a plurality of electrically connected battery cells, and refers to an assembly that functions as a power supply source by being applied to a specific system or device. Here, the battery assembly may mean a battery module, a battery pack, a battery rack, or a battery bank, but the scope of the present invention is not limited to these entities.

State of Charge (SOC) refers to a current state of charge of a battery, represented in percent points [%], and State of Health (SOH) may be a current condition of a battery compared to its ideal or original conditions, represented in percent points [%].

A nominal capacity (Nominal Capa.) refers to a capacity [Ah] of a battery which is set by a battery manufacturer during development of the battery.

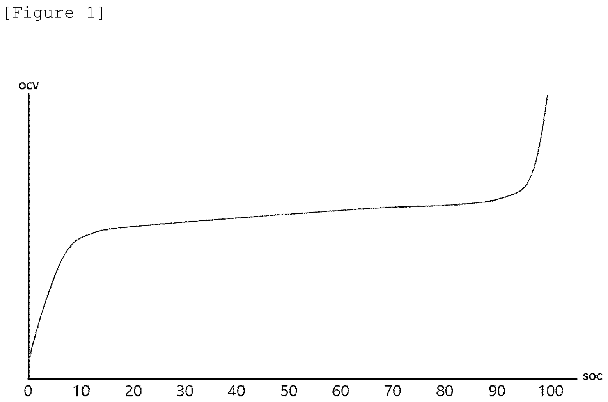

FIG. 1 shows a charging characteristic curve of an LFP battery.

More specifically, FIG. 1 shows a charging characteristic curve of a lithium iron phosphate (LFP) battery in which lithium iron phosphate is used as a cathode active material. The charging characteristic curve represents a correspondence between an open circuit voltage (OCV) and a SOC measured during a battery charging process.

In order to resolve imbalance between battery cells during operation of the battery system, the battery management system may compare SOCs of the battery cells to determine an imbalance state and, upon the imbalance state exceeding a predefined threshold level, balancing control may be performed. Here, a method of measuring an open-circuit voltage value of the battery and estimating an SOC of the battery based on the measured open-circuit voltage value is mainly used, in order to determine imbalance between battery cells.

Referring to FIG. 1, the charging characteristic curve of the LFP battery has a voltage plateau in the SOC range of about 10% to about 90%. In the case of an LFP battery having such a plateau characteristic, it is difficult to accurately estimate the SOC in the plateau section, so balancing control is performed only in a non-flat section (eg, a section where the SOC is 90% or more, or a section where the SOC is 10% or less). In other words, in a battery system to which the LFP battery is applied, the operational stability of the system is limited because balancing control is possible only in a very limited SOC section.

The present invention, which is presented to solve the problems of the prior art, relates to a battery balancing method capable of balancing control in a wider SOC range than that of the prior art, and a battery system performing the same.

Hereinafter, preferred embodiments according to the present invention will be described in detail with reference to the accompanying drawings.

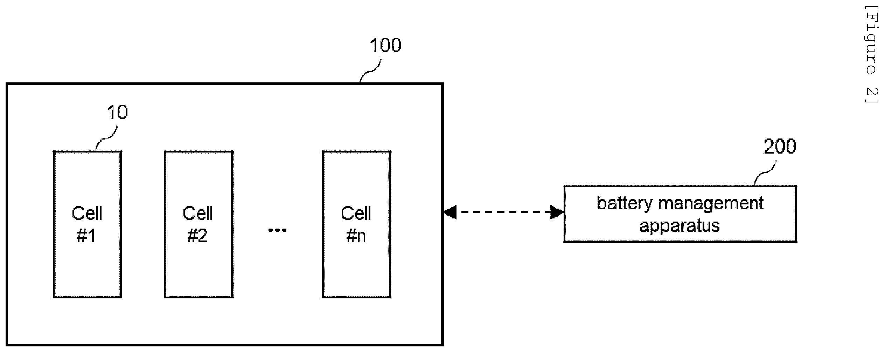

FIG. 2 is a block diagram illustrating a battery system according to the present invention.

Referring to FIG. 2, the battery system includes a battery assembly 100 including a plurality of battery cells 10 and a battery management apparatus 200.

The plurality of battery cells 10 may be electrically connected to each other to form a battery assembly.

The battery cell 10 may correspond to an LFP battery cell, but the scope of the present invention is not limited to this. In other words, the battery cell according to the present invention may correspond to a battery having at least a part of a voltage plateau section in a charging characteristic curve.

The battery management apparatus 200 may manage and control the battery assembly 100 by collecting state information on the plurality of battery cells 10 and performing a predefined control operation based on the collected state information. Here, the battery management apparatus 200 may control charging and discharging of battery cells, diagnose whether battery cells are out of order, and determine an imbalanced state of battery cells to perform balancing control.

The battery management apparatus 200 may be implemented by being included in a battery management system (BMS) located inside a battery system.

The battery system according to embodiments of the present invention may be implemented by being included in an energy storage system (ESS), but the scope of the present invention is not limited thereto. In other words, the battery system according to the present invention may be applied to various devices such as electric vehicles.

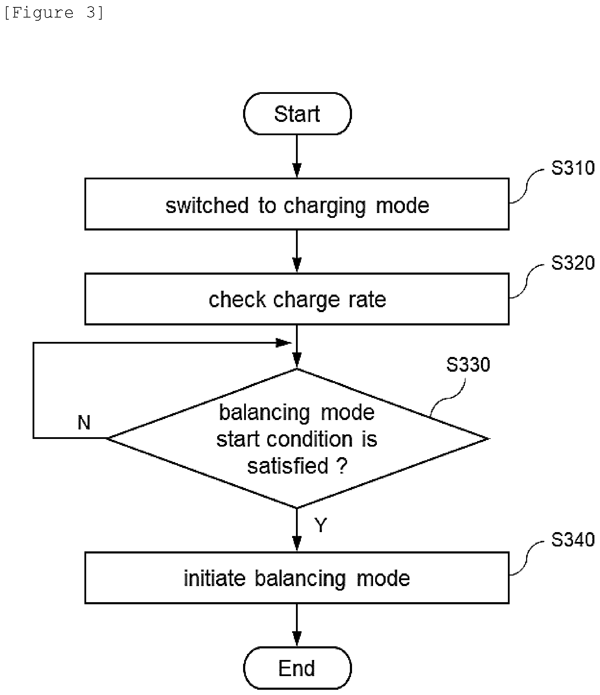

FIG. 3 is an operation flowchart of a battery balancing method according to embodiments of the present invention.

Upon the battery system being switched to a charging mode (S310), the battery management apparatus 200 may check a charge rate of the battery assembly 100 (S320). Here, the charge rate may mean a CP-rate (Constant Power-rate) or C-rate (Current-rate) for charging the battery assembly 100.

The battery management apparatus 200 may check the charge rate from a charging/discharging device (not shown) that charges the battery assembly 100, or check the charge rate based on a state value of one or more of a charging voltage value and a charging current value which may be sensed through one or more of a voltage sensor and a current sensor included in the battery system.

The battery management apparatus 200 may determine whether to initiate a balancing mode for balancing a plurality of battery cells by determining whether a predefined balancing mode start condition is satisfied based on the checked charge rate (S330).

If the balancing mode start condition is satisfied, the battery management apparatus 200 may initiate a balancing mode (S340).

The balancing mode starting condition according to embodiments of the present invention may be defined based on a charge rate.

In an embodiment, the balancing mode starting condition may be defined as a state in which a threshold voltage value or threshold SOC, which is stored in correspondence to the charge rate, is reached.

For example, when the battery assembly is being charged at 0.10 CP, the battery management apparatus 200 may check the voltage value of the battery assembly every predefined time during the charging process, and, when the voltage value of the battery assembly reaches a threshold voltage value (e.g., 3.4009 V) which is predefined corresponding to 0.10 CP (balancing mode start condition is satisfied), the start of the balancing mode may be determined.

For another example, when the battery assembly is being charged at 0.50 C, the battery management apparatus 200 may check the SOC of the battery assembly at every predefined time during the charging process, and, when the SOC of the battery assembly reaches a threshold SOC (e.g., 86) which is predefied corresponding to 0.50 C (balancing mode start condition is satisfied), the start of the balancing mode may be determined.

When the balancing mode is initiated, the battery management apparatus 200 may determine whether balancing is required and perform at least one predefined control operation for balancing, if balancing is required.

More specifically, when the balancing mode start condition is satisfied and the balancing mode is started, the battery management apparatus 200 may collect state information (eg, voltage value or SOC) of a plurality of battery cells. Thereafter, the battery management apparatus 200 may determine whether balancing is required by determining whether a predefined imbalance condition is satisfied based on the collected state information. For example, the imbalance condition may be defined as a state in which a difference between a minimum value and a maximum value among state values (voltage value or SOC) of battery cells is greater than or equal to a predetermined threshold value. When the imbalance condition is satisfied and it is determined that a balancing is required, the battery management apparatus 200 may perform at least one predefined balancing control operation. Here, the at least one balancing control operation may include an operation of reducing unbalanced state between battery cells by controlling a balancing circuit included in the battery system. For example, the battery management apparatus 200 may control a cell balancing circuit to reduce a voltage deviation or an SOC deviation between battery cells. Somehow, the balancing control technique may be a known technique such as a manual balancing control technique, and a detailed description thereof will be omitted because specific details about the balancing technique and the balancing circuit is not an essential configuration of the present invention.

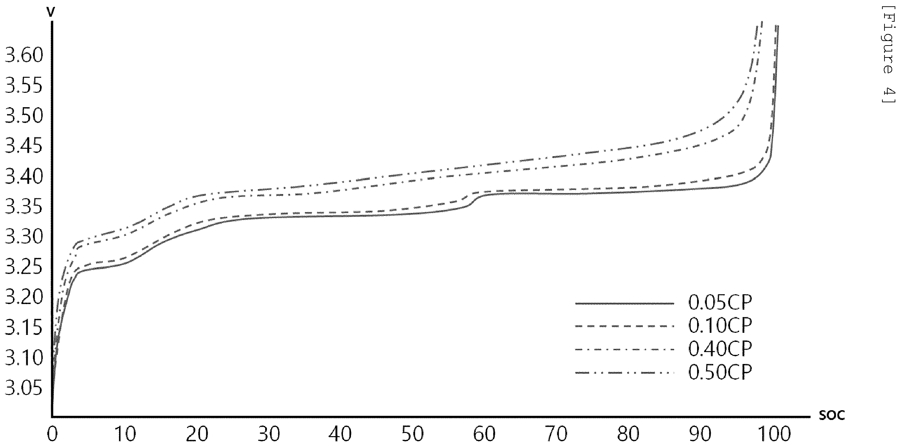

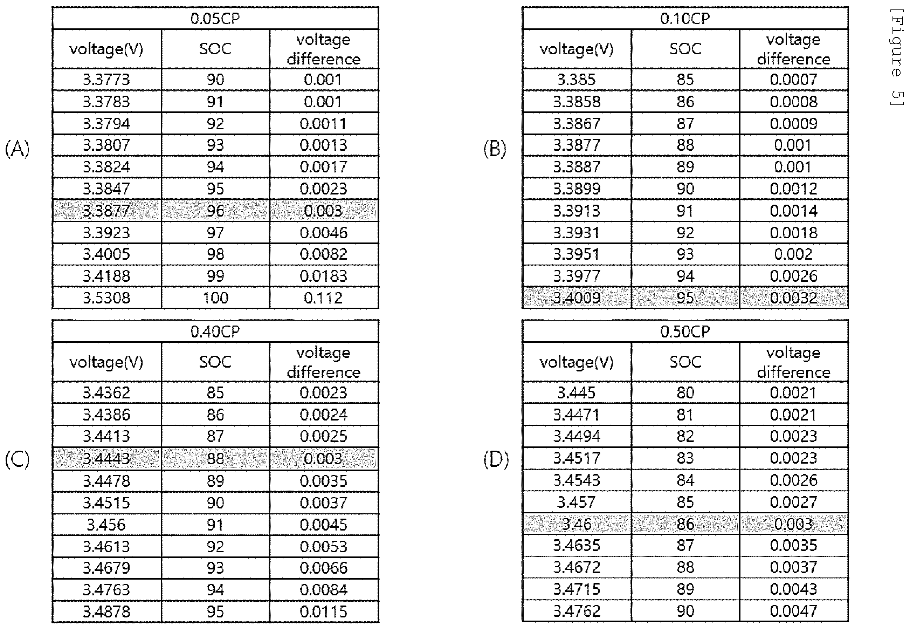

FIG. 4 is a reference diagram for explaining a battery balancing method according to embodiments of the present invention and FIG. 5 is a reference table for explaining a battery balancing method according to embodiments of the present invention.

The battery management apparatus 200 may determine whether to initiate a balancing mode by determining whether a predefined balancing mode start condition is satisfied based on a charge rate of the battery assembly. Here, the balancing mode starting condition may be defined as a state in which a threshold voltage value or threshold SOC, which is stored in correspondence to the charge rate, is reached.

The threshold SOC according to embodiments of the present invention may be defined as a lower value as the charge rate of the battery assembly increases. In addition, a threshold voltage value according to embodiments of the present invention may be defined as a voltage value corresponding to the threshold SOC in the charging characteristic curve.

FIG. 4 shows a charging characteristic curve derived by performing a pre-charging test while changing the charge rate for a battery assembly to which an LFP battery is applied. In the graph of FIG. 4, the horizontal axis represents the SOC, and the vertical axis represents the voltage value of the battery assembly measured during the charging process.

Referring to FIG. 4, a flat region appears in a wide SOC region as the charge rate is lower, but a flat region appears in a relatively narrow SOC region as the charge rate is higher. This is because, when charging is performed at a high charge rate, voltage due to current and resistance has a high effect on the voltage profile during charging of the LFP battery.

As shown in FIG. 4, the charging characteristic curve according to a high charge rate (e.g., 0.50 CP) shows a slope even in a part (e.g., SOC is 70 to 90%) of the plateau region of the charging characteristic curve of a low charge rate (e.g., 0.05 CP). Accordingly, when charging is performed at a high charge rate, a SOC can be estimated with high accuracy even in a relatively low SOC section, and accurate balancing control can be performed even when switching to a balancing mode in a relatively low SOC section.

Based on the principle explained above, the higher the charge rate of the battery assembly, the lower value the threshold SOC according to embodiments of the present invention may be defined as.

For example, when the battery assembly is being charged at 0.05 CP and the SOC of the battery assembly reaches 96, which is a threshold SOC value defined to correspond to 0.05 CP, a balancing mode may be initiated. On the other hand, when the battery assembly is being charged at 0.50 CP and the SOC of the battery assembly reaches 86, which is lower than 96, but is the threshold SOC defined corresponding to 0.50 CP, a balancing mode may be initiated.

As another example, when the battery assembly is being charged with 0.05 CP and the voltage value of the battery assembly reaches 3.3877 V (voltage value corresponding to the threshold SOC), which is a defined threshold voltage value corresponding to 0.05 CP, a balancing mode may be initiated. On the other hand, when the battery assembly is being charged with 0.50 CP and the voltage value of the battery assembly reaches 3.46 V (a voltage value corresponding to the threshold SOC of 86) defined in correspondence with 0.50 CP, a balancing mode may be initiated.

According to embodiments, the threshold voltage value or threshold SOC may be predefined based on voltage-SOC correspondence values, a voltage-SOC correspondence curve, or a voltage-SOC correspondence table derived in a pre-charging process according to the charge rate of the battery assembly.

FIG. 5 is a voltage-SOC correspondence table obtained by performing pre-charging while changing the charge rate for a battery assembly to which an LFP battery is applied. FIGS. 5(A) to 5(D) show correspondence tables between voltage and SOC according to charge rates of 0.05, 0.10, 0.40, and 0.50 CP, respectively.

In an embodiment, the threshold voltage value may be defined as a voltage value at a point where a change amount of the voltage value relative to an unit change amount of SOC is equal to or greater than a predetermined reference value. Here, the reference value may be set based on measurement accuracy of a voltage measuring device included in the battery system.

For example, referring to (A) of FIG. 5, when the charge rate is 0.05 CP, the voltage difference gradually increases as the SOC increases by 1. Here, the threshold voltage value may be defined as 3.3877 V, which is a voltage value at a point where the voltage difference becomes equal to or greater than a predefined reference value of 0.03 V (e.g., a minimum voltage value that can be distinguished by a voltage measuring device). In other words, when the battery assembly enters a state in which an unbalanced state can be determined through the voltage measuring device, the battery management apparatus may initiate a battery balancing mode.

In an embodiment, the threshold SOC may be defined as an SOC value at a point where a change amount in voltage value relative to a unit change in SOC is equal to or greater than a predetermined reference value. For example, referring to (A) of FIG. 5, when the charge rate is 0.05 CP, the threshold SOC may be defined as 96, which is the SOC at the point where the voltage difference becomes equal to or greater than a predefined reference value (0.03 V).

In the same way as above, when the charge rate is 0.10 CP (see (B) of FIG. 5), the threshold voltage value is defined as 3.4009 V and the threshold SOC is 95. In addition, when the charge rate is 0.40 CP (see (C) of FIG. 5), the threshold voltage value is defined as 3.4443 V and the threshold SOC is defined as 88. Furthremore, when the charge rate is 0.50 CP (see (D) of FIG. 5), the threshold voltage value may be defined as 3.46 V and the threshold SOC as 86.

Meanwhile, threshold voltage values or threshold SOCs for charge rates which are not performed in a pre-charging test process may be estimated and defined based on predefined values. For example, as shown in FIG. 5, when preliminary tests are performed only for charge rates of 0.05, 0.10, 0.40, and 0.50 CP, threshold SOCs for 0.02 and 0.03 CP may be defined (for example, as 93, 91) by estimation using correlation between charge rates (0.05, 0.10, 0.40, and 0.50) and threshold SOCs (96, 95, 88, and 86).

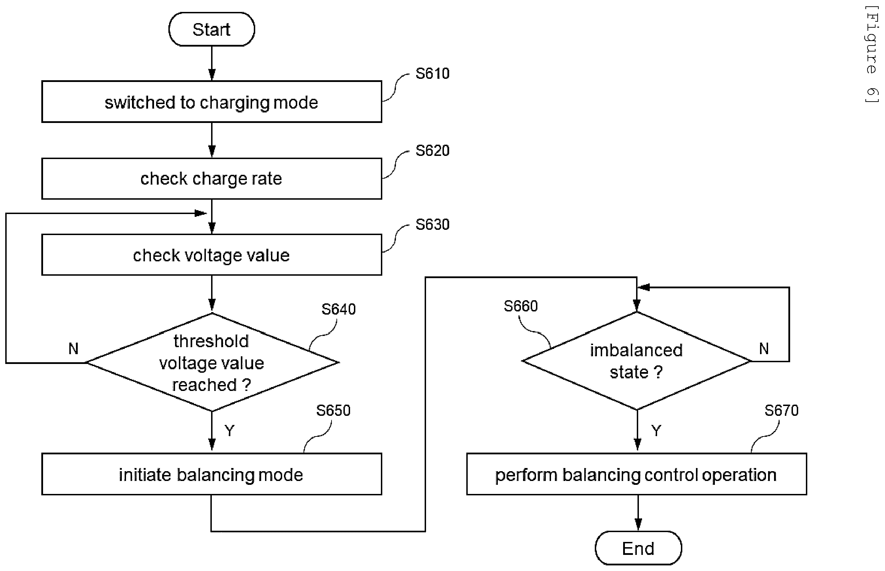

FIG. 6 is an operation flowchart of a battery balancing method based on a threshold voltage value according to an embodiment of the present invention.

When the battery system is switched to a charging mode (S610), the battery management apparatus 200 may check the charge rate of the battery assembly 100 (S620). Here, the charge rate may mean a CP-rate (Constant Power-rate) or C-rate (Current-rate) for charging the battery assembly 100.

The battery management apparatus 200 may check the voltage value of the battery assembly at predetermined time intervals during a charging process of the battery assembly 100 (S630).

The battery management apparatus 200 may determine whether the voltage value of the battery assembly reaches a threshold voltage value which is predefined corresponding to the charge rate checked in S620 (S640).

Here, the threshold voltage value may be predefined based on voltage-SOC correspondence values, a voltage-SOC correspondence curve, or a voltage-SOC correspondence table derived in a pre-charging process according to the charge rate of the battery assembly. In an embodiment, the threshold voltage value may be defined as a voltage value at a point where a change amount of the voltage value relative to a unit change amount of SOC becomes equal to or greater than a predetermined reference value.

When the voltage value of the battery assembly reaches a predefined threshold voltage value (Y in S640), the battery management apparatus 200 may determine to initiate a balancing mode (S650).

When the balancing mode starts, the battery management apparatus 200 may determine whether balancing is required by determining whether a predefined imbalance condition is satisfied based on state information on a plurality of battery cells (S660). Here, the imbalance condition may be defined as a state in which a difference between a minimum value and a maximum value among state values (voltage values or SOCs) of battery cells is greater than or equal to a predetermined threshold value.

When the imbalance condition is satisfied and it is determined that balancing is required (Y in S660), the battery management apparatus 200 may perform at least one predefined balancing control operation (S670). Here, the at least one balancing control operation may include an operation of reducing an unbalanced state between battery cells by controlling a balancing circuit included in the battery system. For example, the battery management apparatus 200 may control a cell balancing circuit to reduce a voltage deviation or an SOC deviation between battery cells.

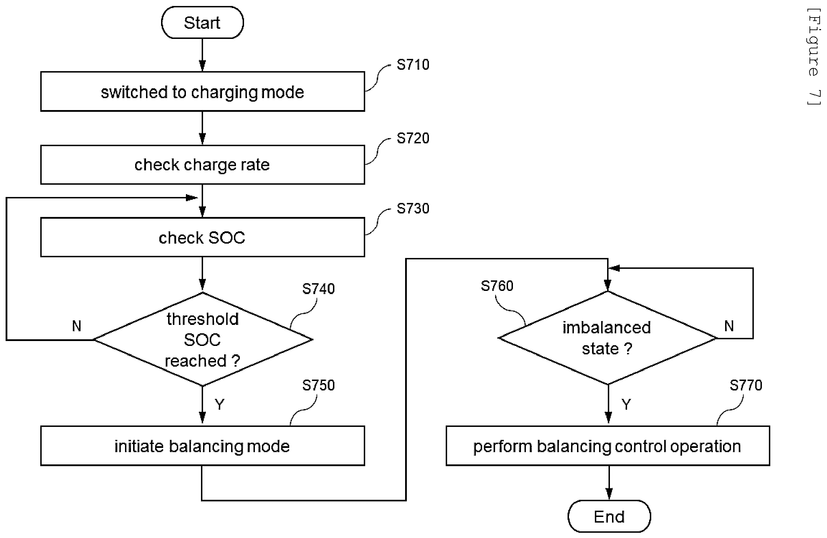

FIG. 7 is an operation flowchart of a battery balancing method based on a threshold SOC according to another embodiment of the present invention.

When the battery system is switched to a charging mode (S710), the battery management apparatus 200 may check a charge rate of the battery assembly 100 (S720). Here, the charge rate may mean a CP-rate (Constant Power-rate) or C-rate (Current-rate) for charging the battery assembly 100.

The battery management apparatus 200 may check the SOC of the battery assembly at predetermined times during a charging process of the battery assembly 100 (S730). Here, the SOC of the assembly may correspond to a value estimated based on the voltage value of the battery assembly.

The battery management apparatus 200 may determine whether the SOC of the battery assembly reaches a threshold SOC which is predefined in correspondence with the charge rate checked in S720 (S740).

Here, the threshold SOC may be predefined based on voltage-SOC correspondence values, a voltage-SOC correspondence curve, or a voltage-SOC correspondence table which has been derived in a pre-charging process according to the charge rate of a battery assembly. In an embodiment, the threshold SOC may be defined as a SOC at a point where a change amount in voltage value relative to a unit change in SOC becomes equal to or greater than a predetermined reference value.

When the SOC of the battery assembly reaches a predefined threshold SOC (Y in S740), the battery management apparatus 200 may determine to initiate a balancing mode (S750).

Upon the balancing mode starting, the battery management apparatus 200 may determine whether balancing is required by determining whether a predefined imbalance condition is satisfied based on state information on a plurality of battery cells (S760). Here, the imbalance condition may be defined as a state in which a difference between a minimum value and a maximum value among state values (voltage values or SOCs) of battery cells is greater than or equal to a predetermined threshold value.

When the imbalance condition is satisfied and it is determined that balancing is required (Y in S760), the battery management apparatus 200 may perform a predefined balancing control operation (S770).

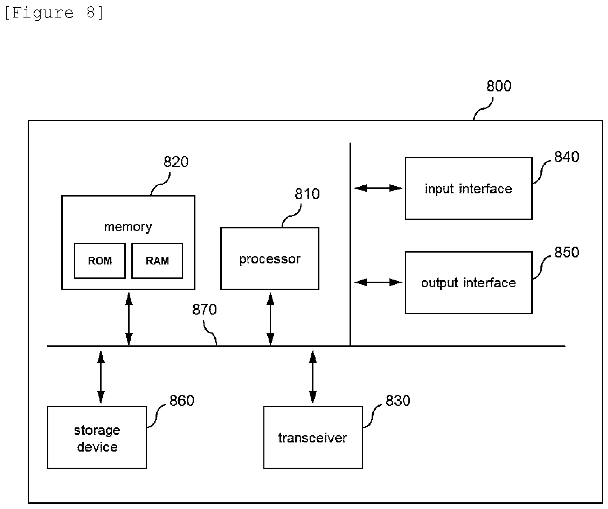

FIG. 8 is a block diagram of a battery management apparatus according to embodiments of the present invention.

The battery management apparatus 800 according to embodiments of the present invention may be located in a battery system and operate in connection with a battery assembly including a plurality of battery cells. The battery management apparatus 800 may include at least one processor 810, a memory 820 that stores at least one instruction executed by the processor, and a transceiver 830 connected to a network to perform communication.

The at least one instruction may include: an instruction to check a charge rate of the battery assembly in a charging mode of the battery assembly; and an instruction to determine whether to start a balancing mode for balancing the plurality of battery cells based on the checked charge rate.

The instruction to check a charge rate of the battery assembly may include an instruction to, upon being switched to the charging mode of the battery assembly, check a constant power-rate (CP-rate) or a current-rate (C-rate) for charging the battery assembly.

The instruction to determine whether to start a balancing mode may include an instruction to determine whether to start a balancing mode based on whether a pre-stored threshold voltage value or threshold SOC corresponding to the checked charge rate is reached.

The instruction to determine whether to start a balancing mode may include an instruction to, in a process of charging the battery assembly, check a voltage value of the battery assembly at every predetermined time; and an instruction to initiate a balancing mode when the voltage value reaches the threshold voltage value.

The instruction to determine whether to start a balancing mode may include an instruction to, in a process of charging the battery assembly, check a voltage value of the battery assembly at every predetermined time; and an instruction to initiate a balancing mode in the instance that a state of charge (SOC) which is calculated based on the voltage value reaches the threshold SOC.

The at least one instruction may further include, upon a balancing mode being initiated, an instruction to determine whether balancing is necessary based on the state information on the plurality of battery cells; and an instruction to perform at least one predefined control operation for balancing the plurality of battery cells when it is determined that balancing is necessary.

The battery management apparatus 800 may further include an input interface 840, an output interface 850, a storage device 860, and the like. Respective components included in the battery management system 800 may be connected by a bus 870 to communicate with each other.

Here, the processor 810 may mean a central processing unit (CPU), a graphics processing unit (GPU), or a dedicated processor on which methods according to embodiments of the present invention are performed. The memory (or storage device) may include at least one of a volatile storage medium and a nonvolatile storage medium. For example, the memory may include at least one of read only memory (ROM) and random access memory (RAM) .

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the scope of the present invention described in the appending claims.

## Claims

1. A battery management apparatus (200, 800) for being connected with a battery assembly (100) including a plurality of battery cells (10);
wherein the battery management apparatus (200, 800) is configured for collecting state information on the battery assembly (100) and for managing and controlling the battery assembly (100) based on the collected state information,
wherein the battery management apparatus (200, 800) is configured to, in a charging mode of the battery assembly (100), check a charge rate of the battery assembly (100), and determine whether to initiate a balancing mode for balancing the plurality of battery cells (10) based on the checked charge rate;
wherein the battery management apparatus (200, 800) is configured to, upon being switched (S610) to the charging mode of the battery assembly (100), check (S620) a constant power-rate (CP-rate) or a current-rate (C-rate) for charging the battery assembly (100); and
wherein the battery management apparatus (200, 800) is configured to determine whether to initiate a balancing mode based on whether a pre-stored threshold voltage value or threshold SOC (86) corresponding to the checked charge rate is reached (S640).

2. The battery management apparatus of claim 1, wherein the battery management apparatus (200, 800) is configured to, in a process of charging the battery assembly (100), check a voltage value of the battery assembly (100) at every predetermined time and initiate a balancing mode in the instance that the voltage value reaches the threshold voltage value.

3. The battery management apparatus of claim 1, wherein the battery management apparatus (200, 800) is configured to, in a process of charging the battery assembly (100), check a voltage value of the battery assembly (100) at every predetermined time and initiate a balancing mode in the instance that a state of charge (SOC) which is calculated based on the voltage value reaches the threshold SOC (86).

4. The battery management apparatus of claim 1, wherein a lower value for the threshold SOC (86) is defined as the charge rate of the battery assembly increases.

5. The battery management apparatus of claim 1, wherein the threshold voltage value or the threshold SOC (86) is predefined based on a voltage-SOC correspondence curve or a voltage-SOC correspondence table derived in a pre-charging process according to the charge rate of the battery assembly (100).

6. The battery management apparatus of claim 5, wherein the threshold voltage value is defined as a voltage value at a point where a change amount in voltage value versus a unit change amount in SOC becomes greater than or equal to a preset reference value.

7. The battery management apparatus of claim 5, wherein the threshold SOC (86) is defined as a SOC at a point where a change amount in voltage value versus a unit change amount in SOC becomes greater than or equal to a preset reference value.

8. The battery management apparatus of claim 1, wherein the battery management apparatus (200, 800) is configured to, upon the balancing mode being initiated, determine whether balancing is necessary based on the state information on the plurality of battery cells (10) and perform at least one predefined control operation for balancing the plurality of battery cells (10) when it is determined that balancing is necessary.

9. A battery management system comprising:
a) a battery assembly (100) including a plurality of battery cells (10);
b) the battery management apparatus (200, 800) according to any one of claims 1 to 8.

10. A battery balancing method to be performed by a battery management apparatus (200, 800) connected with a battery assembly (100) including a plurality of battery cells (10), the method comprising:
checking a charge rate of the battery assembly (100) in a charging mode of the battery assembly (100); and
determining whether to initiate a balancing mode for balancing the plurality of battery cells (10) based on the checked charge rate;
wherein the battery management apparatus (200, 800) is configured to, upon being switched to a charging mode of the battery assembly (100), check a constant power-rate (CP-rate) or a current-rate (C-rate) for charging the battery assembly (100); and
wherein the battery management apparatus (200, 800) is configured to determine whether to initiate a balancing mode based on whether a pre-stored threshold voltage value or threshold SOC (86) corresponding to the checked charge rate is reached.

## Patentansprüche

1. Batteriemanagementvorrichtung (200, 800) zur Verbindung mit einer Batterieanordnung (100), die eine Mehrzahl von Batteriezellen (10) umfasst;
wobei die Batteriemanagementvorrichtung (200, 800) dazu eingerichtet ist, Zustandsinformationen über die Batterieanordnung (100) zu erfassen und die Batterieanordnung (100) auf Grundlage der erfassten Zustandsinformationen zu verwalten und zu steuern,
wobei die Batteriemanagementvorrichtung (200, 800) dazu eingerichtet ist, in einem Lademodus der Batterieanordnung (100) eine Laderate der Batterieanordnung (100) zu prüfen und auf Grundlage der geprüften Laderate zu bestimmen, ob ein Ausgleichsmodus zum Ausgleichen der Mehrzahl von Batteriezellen (10) einzuleiten ist;
wobei die Batteriemanagementvorrichtung (200, 800) dazu eingerichtet ist, beim Umschalten (S610) in den Lademodus der Batterieanordnung (100) eine Konstantleistungsrate (CP-Rate) oder eine Stromrate (C-Rate) zum Laden der Batterieanordnung (100) zu prüfen (S620); und
wobei die Batteriemanagementvorrichtung (200, 800) dazu eingerichtet ist, in Abhängigkeit davon, ob ein vorab gespeicherter Schwellenspannungswert oder SOC-Schwellenwert (86), der der geprüften Laderate entspricht, erreicht wird (S640), zu bestimmen, ob ein Ausgleichsmodus einzuleiten ist.

2. Batteriemanagementvorrichtung nach Anspruch 1, wobei die Batteriemanagementvorrichtung (200, 800) dazu eingerichtet ist, während eines Ladevorgangs der Batterieanordnung (100) zu jedem vorbestimmten Zeitpunkt einen Spannungswert der Batterieanordnung (100) zu prüfen und für den Fall, dass der Spannungswert den Schwellenspannungswert erreicht, einen Ausgleichsmodus einzuleiten.

3. Batteriemanagementvorrichtung nach Anspruch 1, wobei die Batteriemanagementvorrichtung (200, 800) dazu eingerichtet ist, während eines Ladevorgangs der Batterieanordnung (100) zu jedem vorbestimmten Zeitpunkt einen Spannungswert der Batterieanordnung (100) zu prüfen und für den Fall, dass ein Ladezustand (SOC), der auf Grundlage des Spannungswerts berechnet wird, den SOC-Schwellenwert (86) erreicht, einen Ausgleichsmodus einzuleiten.

4. Batteriemanagementvorrichtung nach Anspruch 1, wobei mit zunehmender Laderate der Batterieanordnung ein niedrigerer Wert für den SOC-Schwellenwert (86) festgelegt ist.

5. Batteriemanagementvorrichtung nach Anspruch 1, wobei der Schwellenspannungswert oder der SOC-Schwellenwert (86) auf Grundlage einer Spannungs-SOC-Zuordnungskurve oder einer Spannungs-SOC-Zuordnungstabelle vordefiniert ist, die in einem Vorladevorgang entsprechend der Laderate der Batterieanordnung (100) abgeleitet wurde.

6. Batteriemanagementvorrichtung nach Anspruch 5, wobei der Schwellenspannungswert als ein Spannungswert an einem Punkt definiert ist, an dem ein Änderungsbetrag des Spannungswerts im Verhältnis zu einem Einheitsänderungsbetrag des SOC größer als oder gleich einem voreingestellten Referenzwert wird.

7. Batteriemanagementvorrichtung nach Anspruch 5, wobei der SOC-Schwellenwert (86) als ein SOC-Wert an einem Punkt definiert ist, an dem ein Änderungsbetrag des Spannungswerts im Verhältnis zu einem Einheitsänderungsbetrag des SOC größer als oder gleich einem voreingestellten Referenzwert wird.

8. Batteriemanagementvorrichtung nach Anspruch 1, wobei die Batteriemanagementvorrichtung (200, 800) dazu eingerichtet ist, sobald der Ausgleichsmodus eingeleitet worden ist, auf Grundlage der Zustandsinformationen über die Mehrzahl von Batteriezellen (10) zu bestimmen, ob ein Ausgleich erforderlich ist, und mindestens eine vordefinierte Steueroperation zum Ausgleichen der Mehrzahl von Batteriezellen (10) durchzuführen, wenn bestimmt wird, dass ein Ausgleich erforderlich ist.

9. Batteriemanagementsystem, umfassend:
a) eine Batterieanordnung (100), die eine Mehrzahl von Batteriezellen (10) umfasst;
b) die Batteriemanagementvorrichtung (200, 800) nach einem der Ansprüche 1 bis 8.

10. Batterieausgleichsverfahren, das von einer Batteriemanagementvorrichtung (200, 800) durchzuführen ist, die mit einer Batterieanordnung (100) verbunden ist, welche eine Mehrzahl von Batteriezellen (10) umfasst, wobei das Verfahren umfasst:
Prüfen einer Laderate der Batterieanordnung (100) in einem Lademodus der Batterieanordnung (100); und
Bestimmen, ob auf Grundlage der geprüften Laderate ein Ausgleichsmodus zum Ausgleichen der Mehrzahl von Batteriezellen (10) einzuleiten ist;
wobei die Batteriemanagementvorrichtung (200, 800) dazu eingerichtet ist, beim Umschalten in einen Lademodus der Batterieanordnung (100) eine Konstantleistungsrate (CP-Rate) oder eine Stromrate (C-Rate) zum Laden der Batterieanordnung (100) zu prüfen; und
wobei die Batteriemanagementvorrichtung (200, 800) dazu eingerichtet ist, in Abhängigkeit davon, ob ein vorab gespeicherter Schwellenspannungswert oder SOC-Schwellenwert (86), der der geprüften Laderate entspricht, erreicht wird, zu bestimmen, ob ein Ausgleichsmodus einzuleiten ist.

## Revendications

1. Dispositif de gestion de batterie (200, 800) destiné à être connecté à un bloc-batterie (100) comprenant une pluralité de cellules de batterie (10).
où ledit dispositif de gestion de batterie (200, 800) est prévu pour recueillir des informations d'état sur le bloc-batterie (100) et pour gérer et commander le bloc-batterie (100) sur la base des informations d'état collectées,
où ledit dispositif de gestion de batterie (200, 800) est prévu pour, dans un mode de charge du bloc-batterie (100), contrôler un taux de charge du bloc-batterie (100), et déterminer s'il convient de déclencher un mode d'équilibrage pour équilibrer la pluralité de cellules de batterie (10) sur la base du taux de charge contrôlé ;
où ledit dispositif de gestion de batterie (200, 800) est prévu pour, par commutation (S610) vers le mode de charge du bloc-batterie (100), contrôler (S620) un débit de puissance constant (débit CP) ou un débit de courant (débit C) pour charger le bloc-batterie (100) ; et où ledit dispositif de gestion de batterie (200, 800) est prévu pour déterminer s'il convient de déclencher un mode d'équilibrage si une valeur de tension seuil ou un état de charge seuil pré-mémorisés (86) correspondant au taux de charge contrôlé sont atteints (S640).

2. Dispositif de gestion de batterie selon la revendication 1, où ledit dispositif de gestion de batterie (200, 800) est prévu pour, lors d'un processus de charge du bloc-batterie (100), contrôler une valeur de tension du bloc-batterie (100) à chaque moment prédéterminé et déclencher un mode d'équilibrage dans le cas où la valeur de tension atteint la valeur de tension seuil.

3. Dispositif de gestion de batterie selon la revendication 1, où ledit dispositif de gestion de batterie (200, 800) est prévu pour, lors d'un processus de charge du bloc-batterie (100), contrôler une valeur de tension du bloc-batterie (100) à chaque moment prédéterminé et déclencher un mode d'équilibrage dans le cas où un état de charge (SOC) calculé sur la base de la valeur de tension atteint le SOC seuil (86).

4. Dispositif de gestion de batterie selon la revendication 1, où une valeur inférieure pour le SOC seuil (86) est définie lorsque le taux de charge du bloc-batterie augmente.

5. Dispositif de gestion de batterie selon la revendication 1, où la valeur de tension seuil ou le SOC seuil (86) sont prédéfinis sur la base d'une courbe de correspondance tension-SOC ou d'une table de correspondance tension-SOC déduite lors d'un processus de précharge en fonction du taux de charge du bloc-batterie (100).

6. Dispositif de gestion de batterie selon la revendication 5, où la valeur de tension seuil est définie en tant que valeur de tension à un moment où une quantité de variation de valeur de tension opposée à une quantité de variation unitaire du SOC devient supérieure ou égale à une valeur de référence prédéfinie.

7. Dispositif de gestion de batterie selon la revendication 5, où le SOC seuil (86) est défini en tant que SOC à un moment où une quantité de variation de valeur de tension opposée à une quantité de variation unitaire du SOC devient supérieure ou égale à une valeur de référence prédéfinie.

8. Dispositif de gestion de batterie selon la revendication 1, où ledit dispositif de gestion de batterie (200, 800) est prévu pour, par déclenchement du mode d'équilibrage, déterminer si un équilibrage est nécessaire sur la base des informations d'état sur la pluralité de cellules de batterie (10). et exécuter au moins une opération de commande prédéfinie afin d'équilibrer la pluralité de cellules de batterie (10) s'il est déterminé qu'un équilibrage est nécessaire.

9. Système de gestion de batterie, comprenant :
a) un bloc-batterie (100) comprenant une pluralité de cellules de batterie (10) ;
b) le dispositif de gestion de batterie (200, 800) selon l'une des revendications 1 à 8.

10. Procédé d'équilibrage de batterie à exécuter par un dispositif de gestion de batterie (200, 800) connecté à un bloc-batterie (100) comprenant une pluralité de cellules de batterie (10), ledit procédé comprenant :
le contrôle d'un taux de charge du bloc-batterie (100) dans un mode de charge du bloc-batterie (100) ; et
la détermination s'il convient de déclencher un mode d'équilibrage pour équilibrer la pluralité de cellules de batterie (10) sur la base du taux de charge contrôlé ;
où le dispositif de gestion de batterie (200, 800) est prévu pour, par commutation (S610) vers le mode de charge du bloc-batterie (100), contrôler un débit de puissance constant (débit CP) ou un débit de courant (débit C) pour charger le bloc-batterie (100) ; et
où le dispositif de gestion de batterie (200, 800) est prévu pour déterminer s'il convient de déclencher un mode d'équilibrage si une valeur de tension seuil ou un état de charge seuil pré-mémorisés (86) correspondant au taux de charge contrôlé sont atteints.
